# EUROPEAN PATENT APPLICATION

(11) **EP 1 191 828 A2**
(43) Date of publication of application: **27.03.2002**
(21) Application number: 01121036.6
(22) Date of filing: 01.09.2001
(51) Int. Cl.: H05K 1/14

(54) **Improvements to printed circuit board connections**

(30) Priority: 25.09.2000 GB 0023435
(71) Applicant: InvaCom Ltd., Business & Technology Center, Stevenage, Herts SG1 2DX (GB)
(72) Inventor: Stafford, Gary Patrick, London Colney, St Albans, Herts AL2 1JP (GB); Smith, David Gerald, Knebworth, Herts SG3 6DX (GB); Davidson, John, Crudwell, Malmesbury, Wilts SN16 9EH (GB)
(74) Representative: Wood, Graham

(57) **Abstract**

The invention to which this application relates is a means for connecting Printed Circuit Boards (PCB's) and in particular to the interconnection of printed circuit boards such that the connections will operate at frequencies of 2.15GHz and beyond although equally can be used for DC or low frequency interconnections. One particular, although not exclusive, use of the invention is as part of a Low Noise Block (LNB). The invention provides for the PCB's (12,14) to be mounted in the apparatus so that at least a portion (28) of the same overlap and connections are achieved between the overlapping portions. A grounding or conducting plate (16) is positioned between the PCB's (12,14). Connection in this manner reduces the number of pins required in comparison to conventional techniques.

## Description

The invention to which this application relates is a means for connecting Printed Circuit Boards (PCB's) and in particular to the interconnection of printed circuit boards such that the connections will operate at frequencies of 2.15GHz and beyond although equally can be used for DC or low frequency interconnections.

One particular, although not exclusive, use of the invention is as part of a Low Noise Block (LNB) which is utilised as part of apparatus for the reception of data broadcast at a remote location and transmitted via satellite to be received at many different locations, each provided with data receiving apparatus including an LNB. The LNB can be a Universal Quad or 4 output (fully switchable) LNB covering the Universal frequency band (10.7-12.75GHz) with dual polarization. This type of unit has 3 PCBs, 2 operating in the 10.7GHz-12.75GHz range, the other operating from 0.95 to 2.15GHz range. The invention applies equally to all other LNB types requiring two or more PCBs which are interconnected, including Twin and Quatro LNB types.

However, it should be noted that the idea can be used in principle on any electrical equipment containing two or more circuit boards that require interconnection, and the reference to the LNB use and embodiment herein is to indicate to the reader the disadvantages which are conventionally experienced and the advantages to be gained by this invention which should not be interpreted as being limited to use with LNB's.

Conventionally, connectors such as pins are used to interconnect PCBs and, at higher frequencies of operation these can be expensive and/or it can prove difficult to maintain signal grounding.

For the specific application of conventional LNBs which includes Universal Twin and Quatro type designs, two PCBs are almost invariably placed either side of a metal plate. The metal plate can, in some instances, be an integral part of the main casting or housing and, in others can be a separate plate. In either case the plate provides RF isolation between the PCB's. Pins are provided which interconnect between the two PCBs and typically 10-15 pins are provided in one LNB which pass through the metal plate. In some cases this sub-assembly is connected to a further PCB also by the use of further interconnect pins. A problem with this is that manufacturing is expensive and time consuming due to the number of pins required to be used and connections may not be properly formed or may decay over time. A further problem is that to maintain the good connection of the PCB's with the pins and metal plate some form of force is required to force the PCB's into contact with the metal plate.

A conventional alternative is to provide cable connections rather than pins but the same problem of manufacture and expense are experienced.

The aim of the present invention is to provide the connector of PCBs in a more cost effective and efficient manner.

In a first aspect of the invention there is provided apparatus including at least two interconnected printed circuit boards (PCB's) characterised in that the first PCB is mounted to overlap a portion of the second PCB and connections are formed between said first and second PCB's at the interconnecting portion of overlap.

Typically a third PCB is provided to overlap and be connected to said first and/or second PCB. Preferably the second PCB is a multilayered PCB with, at one edge of the same, a connection portion, and on a first surface of the PCB an overlapping portion of a first PCB is located and connected on the opposing or second surface of the PCB a third PCB is located and connected.

Typically the PCB'S are connected to opposing surfaces of the connecting portion of the multilayered PCB and the connection between the PCB's at the overlapping portions are achieved using vias or any other suitable connection means.

The said first and third PCB's are separated by a conducting plate with the exception of the portions of the same which overlie the second PCB. In a preferred embodiment the conducting plate is of similar thickness to the second PCB and lies in the same plane as the second PCB in the apparatus, with the conducting plate lying between the first and third PCB's. As a result the connections between the PCB's do not need to pass through the conducting plate.

Typically the first and third PCB's are provided with grounding plates.

In one preferred embodiment of the invention the apparatus is an LNB and the first and third PCB's are isolated and operate in RF mode whereas the second PCB to which the first and third PCB's are connected, operates in Intermediate Frequency (IF) mode.

In a second aspect of the invention there is provided a method of interconnection of at least two PCBs wherein a first PCB is mounted to overlap a portion of the second PCB and connections are formed between said first and second PCB's.

In a preferred embodiment a third PCB is provided to overlap and be connected to said first and/or second PCB.

In one embodiment, the second PCB is a multilayered PCB and at one edge of the same is defined a connection portion, with on a first surface of the PCB an overlapping portion of the first PCB is located and connected and on an opposing or second surface of the second PCB the third PCB is located and connected.

Typically the connection between the PCB's at the overlapping portions are achieved using vias or any suitable connection means but, in any case, the number of pins that are required to be used is reduced to zero or at least greatly reduced as the first and third PCB's can be placed in parallel with a grounding plate mounted therebetween but without the need for all of the connections between the two to pass through apertures in the metal plate.

In one embodiment in the design and provision of the connection between the PCB's a selection is made as to the components which are to be located on the respective PCB's so as to minimise connections which are required to be made.

In one embodiment the first and third PCB's are isolated and operate in RF mode whereas the second PCB to which the first and third PCB's are connected, operates in Intermediate Frequency (IF) mode.

A specific embodiment of the invention is now described with reference to the accompanying drawings, wherein:-
Figures 1A and 1B illustrate top and bottom views of a constructed LNB using the invention;
Figures 2A and 2B illustrate first and second perspective views of the components of the LNB from the top and bottom directions respectively; and

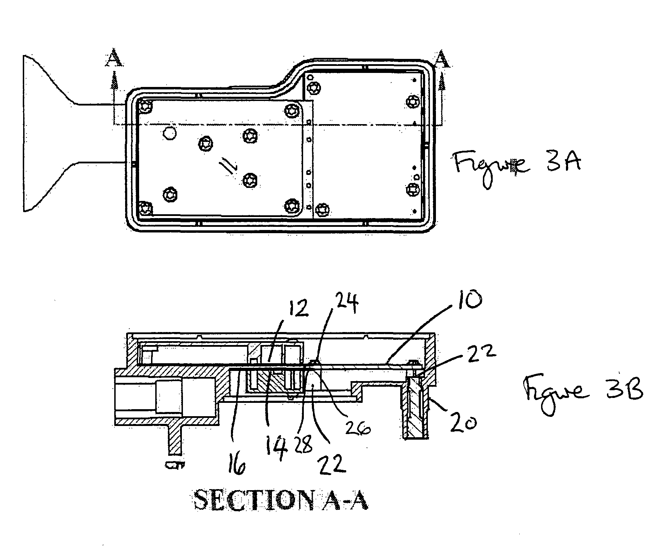

Figures 3A and 3B illustrate in Figure 3B a sectional elevation of the LNB viewing along line A-A of Figure 3A.

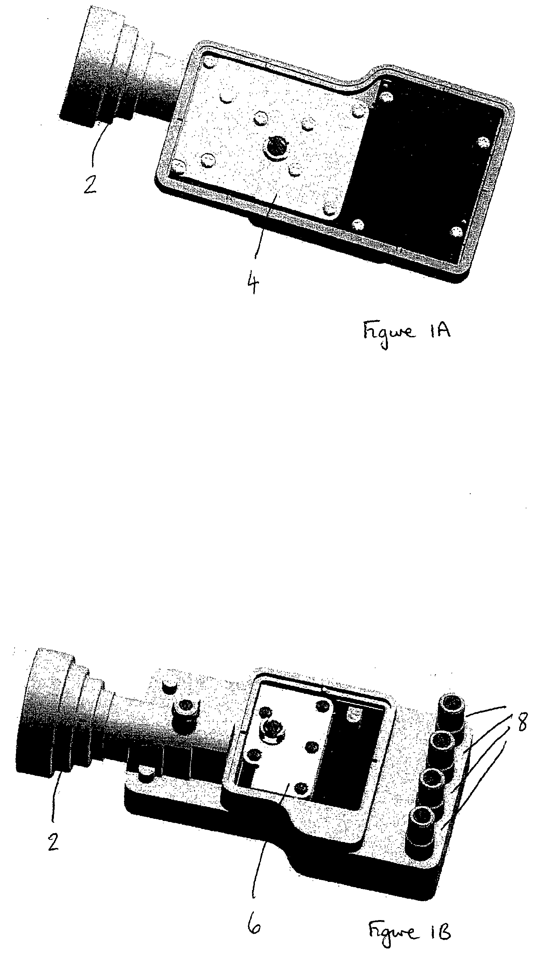

Referring to the figures 1A and 1B, there is shown an LNB manufactured in accordance with the invention and which includes a horn 2, in line with a first PCB not shown, but provided on one side behind a plate 4 and a third PCB, not shown, but provided at the other side of the LNB plate 6. The LNB thus includes, in this mode, four of quad ports 8 mounted perpendicular to the LNB linear axis.

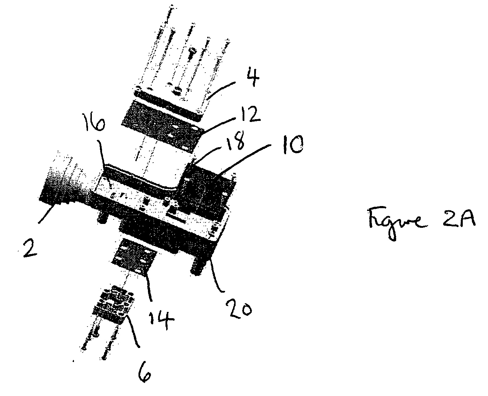

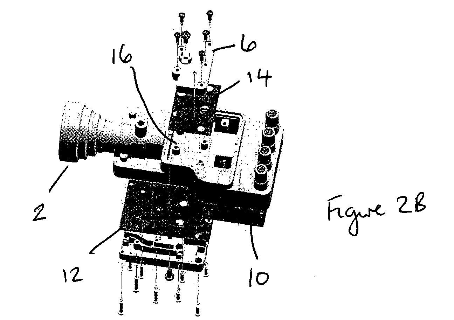

In the specific case of the LNB and as shown in figures 2A and 2B , a backend multilayer PCB 10 is used to carry a relatively complicated switch array, which requires multiple interconnections between the components on the other PCB's 12, 14 on either side of the PCB 10 and separating plate 16. In the conventional case this would be achieved by the use of interconnect pins through apertures in the plate 16 and the switch circuitry would be present on both PCBs 12, 14 which also accommodate RF circuitry. In accordance with the invention a via 18 is used which requires no manual assembly or pins. The use of the via also takes up far less space on the PCB and has consistent performance and grounding characteristics, unlike pins.

To form the LNB in accordance with the invention, the PCB 10 is mounted into a recess in the main housing 20 which is a diecasting. The PCB 10 sits on a number of mounting bosses 22 integrated into the casting. A metal separating or conducting plate 16, which in this case is of similar thickness to the PCB 10, is provided at the same level as the PCB 10. On either side of this metal plate, which in this case is also integral with the main housing, the RF PCB's are placed and these PCBs 12, 14 overlap on respective surfaces 24, 26 of the PCB 10 by a few millimetres to form the connection portion 28.

Pads are provided on the PCB 10 and, through vias on the PCBs 12, 14, which overlap, and with appropriate jigging to keep the PCBs flat and in position, the vias can be hand or automatically soldered, to form the connection.

In this way a compact inter-board connection is achieved with no additional components and, for high frequency operation, grounding is guaranteed since the PCBs are all screwed down locally to the main housing either directly with a screw or fixing on the PCB and/or by the use of the metal (or other) plates 4, 6, fixed to the PCB and fixed down to the main housing.

Several advantages are obtained in accordance with the invention, namely no pins or connectors are required, consistent grounding can be achieved, simple repeatable construction is possible with reduces cost and good operation at high frequencies.

This interconnect technology is clearly applicable to any electrical equipment that requires PCB to PCB interconnections and is especially useful at higher frequencies, well into the GHz frequency range. In particular, mobile phones can benefit from the invention described herein.

With regard to LNB's, the LNB can be "in-line" which is more aesthetically pleasing and enables the LNB to be integrated into the boom arm of the dish, although other benefits as above come free. The use of the multilayer PCB such as the FR4 multilayer PCB, in the backend rather than the conventional arrangement of two or more PCBs and interconnect pins or connectors enables the F-types port connectors 8 to be perpendicular rather than parallel to the PCB's which, for an in-line unit, means that the cables can point towards the ground which makes a significantly smaller and better looking installation than if the F-type connectors were parallel to the LNB.

Also, in a further aspect of the invention and in order to produce such an in-line LNB, a compact front-end waveguide and probe arrangement can be used.

Existing Universal Quad, Universal Twin and Universal Quatro waveguide/probe arrangements for LNB's, being somewhat larger, when combined with the second RF PCB which sits, in the case of an "in-line" LNB, directly behind the waveguide, cause the LNB to be unacceptably long. This increases the cost, makes the unit less aesthetically pleasing and can impact the boom and dish design due to added size and weight. However in conjunction with the PCB connection arrangement herein described, the in-line arrangement can be achieved.

The waveguide front-end design which is adapted enables the preferred LNB shape to be adopted.

Thus the present invention provides a novel and advantageous way of interconnecting PCB's as herein described which has uses and advantage in many different environments and apparatus.

The specific advantages to LNB's are provided as illustrated and should not be interpreted as limiting the scope of the invention.

## Claims

1. Apparatus including at least two interconnected printed circuit boards (PCB's) **characterised in that** the first PCB is mounted to overlap a portion of the second PCB and connections are formed between said first and second PCB's at the interconnecting portion of overlap.

2. Apparatus according to claim 1 **characterised in that** a third PCB is provided to overlap and be connected to said first and/or second PCB.

3. Apparatus according to claim 1 **characterised in that** the second PCB is a multilayered PCB with, at one edge of the same, a connection portion, and on a first surface of the PCB an overlapping portion of a first PCB is located and connected on the opposing or second surface of the PCB a third PCB is located and connected.

4. Apparatus according to claim 3 **characterised in that** the PCB'S are connected to opposing surfaces of the connecting portion of the multilayered PCB.

5. Apparatus according to claim 3 **characterised in that** the connection between the PCB's at the overlapping portions are achieved using vias or any other suitable connection means.

6. Apparatus according to claim 3 **characterised in that** the said first and third PCB's are separated by a conducting plate with the exception of the portions of the same which overlie the second PCB.

7. Apparatus according to claim 6 **characterised in that** the conducting plate is of similar thickness to the second PCB and lies in the same plane as the second PCB in the apparatus.

8. Apparatus according to claim 7 **characterised in that** the conducting plate lies between the first and third PCB's.

9. Apparatus according to claim 6 **characterised in that** the connections between the PCB's do not need to pass through the conducting plate.

10. Apparatus according to claim 1 **characterised in that** three PCB's are provided and the first and third PCB's are offset from and mounted to either side of the second PCB.

11. Apparatus according to claim 10 **characterised in that** the first and third PCB's are provided with grounding plates.

12. Apparatus according to claim 6 **characterised in that** the first and third PCB's are isolated and operate in RF mode whereas the second PCB to which the first and third PCB's are connected, operates in Intermediate Frequency (IF) mode.

13. Apparatus according to any of the preceding claims **characterised in that** the apparatus is an LNB.

14. A method of interconnection of at least two printed circuit boards (PCB's) in electrical apparatus **characterised in that** a first PCB is mounted to overlap a portion of the second PCB and connections are formed between said first and second PCB's with a conducting plate mounted between said first and second PCB's.

15. A method according to claim 14 **characterised in that** a third PCB is provided with first and third PCB's mounted on opposing surfaces of the second PCB.

16. A method according to claim 14 **characterised in that** a selection is made as to the components which are to be located on the respective PCB's so as to minimise connections which are required to be made.
